# EUROPEAN PATENT APPLICATION

(11) **EP 2 597 775 A2**
(43) Date of publication of application: **29.05.2013**
(21) Application number: 12189748.2
(22) Date of filing: 24.10.2012
(51) Int. Cl.: H03K 17/96, G06F 3/02, G06F 3/03

(54) **Key device and electronic equipment**

(30) Priority: 22.11.2011 CN 201110373352; 14.09.2012 US 201213615740
(71) Applicant: Sony Mobile Communications AB, 221 88 Lund (SE)
(72) Inventor: Liu, Yinong, 100102 Beijing (CN)
(74) Representative: Aurell, Henrik

(57) **Abstract**

The embodiments of the present invention provide a key device and an electronic equipment, including a key body, and the key device further includes: one or more touch keys (201) arranged on the key body, the touch keys being contacted such that the capacitance of a capacitive touch sensor is changed; a printed circuit board (202), with one side being arranged the touch keys (201), for inducing the change of the capacitance of the capacitive touch sensor, so as to generate a control signal; and a mechanical key (203) arranged on the other side of the printed circuit board (202), when the key body is pressed, the mechanical key (203) being squeezed to generate an electrical signal. With the embodiments of the present invention, space may be saved, and better experiences may be provided to the users.

## Description

### Technical Field

The present invention relates to the field of electronics, and in particular to a key device and an electronic equipment.

### Background Art

Currently, more and more electronic equipments have multimedia functions. Especially, terminal equipment, which may have multiple mechanical functional keys, such as a volume key, a camera key, and a navigation key, etc.

The volume key may control the volume of the terminal equipment via Up/Down, the camera key may have multiple statuses (such as Free/Focus/Snapshot), and the navigation key may include five control keys for controlling up/down/left/right/ok.

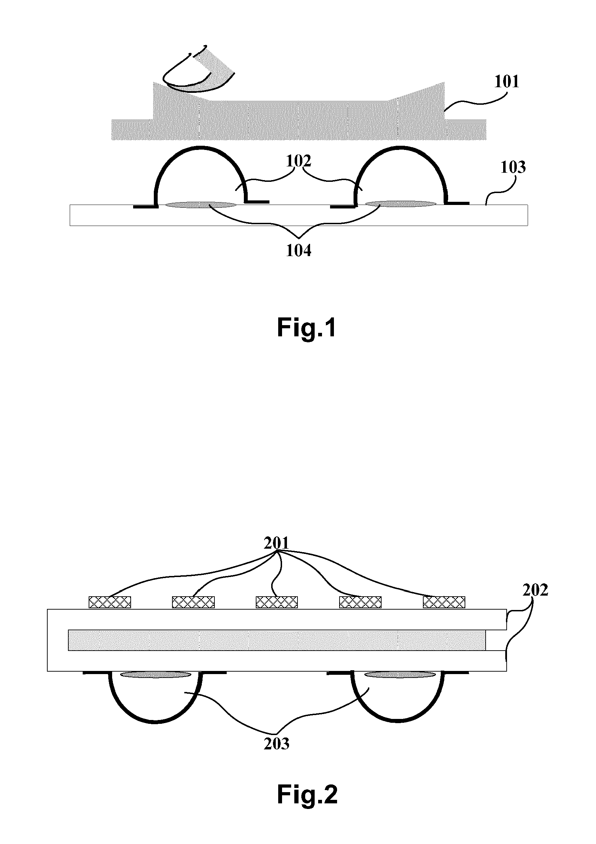

Figure 1 is a schematic diagram of the composition of a mechanical volume key of the prior art. As shown in Fig. 1, the volume key may include a key body 101, a mechanical key (Dome Key) 102 and a metal supporting structure 103. When a user presses the key body 101, a pressure sensor 104 in the mechanical dome key 102 may generate an electrical signal, thereby controlling the volume.

### Summary of the Invention

In the implementation of the present invention, this applicant found that in the prior art, the multiple functional keys of the terminal equipment are arranged separately, which is disadvantageous to space saving, and is incapable of providing better experiences to users.

The embodiments of the present invention provide a key device and an electronic equipment, with the object being to combine capacitive touch and mechanical press, which is advantageous to space saving, and is capable of providing better experiences to users.

According to an aspect of the embodiments of the present invention, there is provided a key device, including a key body, wherein the key device further includes:
one or more touch keys arranged on the key body, the touch keys being contacted such that the capacitance of a capacitive touch sensor is changed;
a printed circuit board, with one side being arranged the touch keys, for inducing the change of the capacitance of the capacitive touch sensor, so as to generate a control signal; and
a mechanical key arranged on the other side of the printed circuit board, when the key body is pressed, the mechanical key being squeezed to generate an electrical signal.

According to another aspect of the embodiments of the present invention, the mechanical key is a dome key.

According to a further aspect of the embodiments of the present invention, the control signal is used to realize a volume function or a camera function.

According to still another aspect of the embodiments of the present invention, the printed circuit board generates a control signal for focusing or shooting according to the time interval of the change of the capacitance of the capacitive touch sensor.

According to still another aspect of the embodiments of the present invention, there are multiple touch keys, and the printed circuit board generates a control signal for changing volume according to the change of the capacitance of multiple capacitive touch sensors.

According to still another aspect of the embodiments of the present invention, the multiple touch keys are arranged linearly.

According to still another aspect of the embodiments of the present invention, the width of each of the touch keys is 2.5 mm, the length is 8.0 mm, and the width between two touch keys is 1.0 mm.

According to still another aspect of the embodiments of the present invention, the control signal is used to realize a navigation function.

According to still another aspect of the embodiments of the present invention, there are multiple touch keys, and the printed circuit board generates a control signal for indicating direction according to the change of the capacitance of multiple capacitive touch sensors.

According to still another aspect of the embodiments of the present invention, the multiple touch keys are arranged circularly

According to still another aspect of the embodiments of the present invention, there is provided electronic equipment, including the key device as stated above.

The advantages of the present invention exist in that with touch keys, a printed circuit board and a mechanical key being arranged within the same key device, capacitive touch and mechanical press may be combined, which is advantageous to space saving, and is capable of providing better experiences to users.

These and further aspects and features of the present invention will be apparent with reference to the following description and attached drawings. In the description and drawings, particular embodiments of the invention have been disclosed in detail as being indicative of some of the ways in which the principles of the invention may be employed, but it is understood that the invention is not limited correspondingly in scope. Rather, the invention includes all changes, modifications and equivalents coming within the spirit and terms of the appended claims.

Features that are described and/or illustrated with respect to one embodiment may be used in the same way or in a similar way in one or more other embodiments and/or in combination with or instead of the features of the other embodiments.

It should be emphasized that the term "comprises/comprising" when used in this specification is taken to specify the presence of stated features, integers, steps or components but does not preclude the presence or addition of one or more other features, integers, steps, components or groups thereof.

Many aspects of the invention can be better understood with reference to the following drawings. The components in the drawings are not necessarily to scale, emphasis instead being placed upon clearly illustrating the principles of the present invention. To facilitate illustrating and describing some parts of the invention, corresponding portions of the drawings may be exaggerated in size, e.g., made larger in relation to other parts than in an exemplary device actually made according to the invention. Elements and features depicted in one drawing or embodiment of the invention may be combined with elements and features depicted in one or more additional drawings or embodiments. Moreover, in the drawings, like reference numerals designate corresponding parts throughout the several views and may be used to designate like or similar parts in more than one embodiment.

### Brief Description of the Drawings

The drawings are included to provide further understanding of the present invention, which constitute a part of the specification and illustrate the preferred embodiments of the present invention, and are used for setting forth the principles of the present invention together with the description. The same element is represented with the same reference number throughout the drawings.

In the drawings:
Figure 1 is a schematic diagram of the composition of a mechanical volume key of the prior art;
Figure 2 is a schematic diagram of the composition of a key device of an embodiment of the present invention;
Figure 3 is a schematic diagram showing the formation of a key device of an embodiment of the present invention;
Figure 4 is a schematic diagram showing another formation of a key device of an embodiment of the present invention;
Figure 5 is a schematic diagram showing generation of signals of two paths of an embodiment of the present invention;
Figure 6 is a schematic diagram showing volume up of an embodiment of the present invention;
Figure 7 is a schematic diagram showing volume down of an embodiment of the present invention;
Figure 8 is a schematic diagram showing arrangement of touch keys of an embodiment of the present invention;
Figure 9 is a schematic diagram showing realization of a navigation function of an embodiment of the present invention; and
Figure 10 is a block diagram of a systematic composition of electronic equipment of an embodiment of the present invention.

### Detailed Description of the Invention

The interchangeable terms "electronic apparatus" and "electronic device" include portable radio communication apparatus. The term "portable radio communication apparatus", which hereinafter is referred to as a "mobile terminal", "portable electronic device", or "portable communication device", includes all apparatuses such as mobile telephones, pagers, communicators, electronic organizers, personal digital assistants (PDAs), smartphones, portable communication devices or the like.

In the present application, embodiments of the invention are described primarily in the context of a portable electronic device in the form of a mobile telephone (also referred to as "mobile phone"). However, it shall be appreciated that the invention is not limited to the context of a mobile telephone and may relate to any type of appropriate electronic apparatus having the function of photographing and sound recording.

An embodiment of the present invention provides a key device, including a key body. Fig. 2 is a schematic diagram of the composition of a key device of an embodiment of the present invention. As shown in Fig. 2, the key device includes touch keys 201, a printed circuit board 202 and a mechanical key 203.

The touch keys 201 are arranged on the key body (not shown), and are contacted by a finger of a user, such that the capacitance of a capacitive touch sensor (not shown) is changed. One side of the printed circuit board 202 is arranged with the touch keys 201, for inducing the change of the capacitance of the capacitive touch sensor, so as to generate a control signal. The mechanical key 203 is arranged on the other side of the printed circuit board 202, and when the key body is pressed, the mechanical key 203 is squeezed to generate an electrical signal.

In this embodiment, the printed circuit board 202 may be a flexible printed circuit board (FPC), and may also be other types of printed circuit boards. Particular type of a printed circuit board may be determined as actually required.

In this embodiment, in particular implementation, the touch keys 201 may be connected to and arranged separately from the capacitive touch sensor, and the touch keys 201 may be integrated with the capacitive touch sensor. Specific implementation may be determined as actually required.

In particular implementation, the touch keys 201 may be of a metal structure. When a finger of a user contacts the touch keys 201, the electrical field of the human body will make capacitance formed between the finger and the touch keys, as the tissues of the skin of the human body are full of conductive electrolytes, thereby changing the capacitance of the capacitive touch sensor. As to the working principle and specific implementations of the capacitive touch sensor, the prior art may be referred to, which shall not be described any further.

In this embodiment, the mechanical key 203 may be a dome key, which may include a pressure sensor.

In this embodiment, the touch keys 201 may be one, connected to one capacitive touch sensor. The touch keys 201 may be multiple, each of which being connected to one capacitive touch sensor.

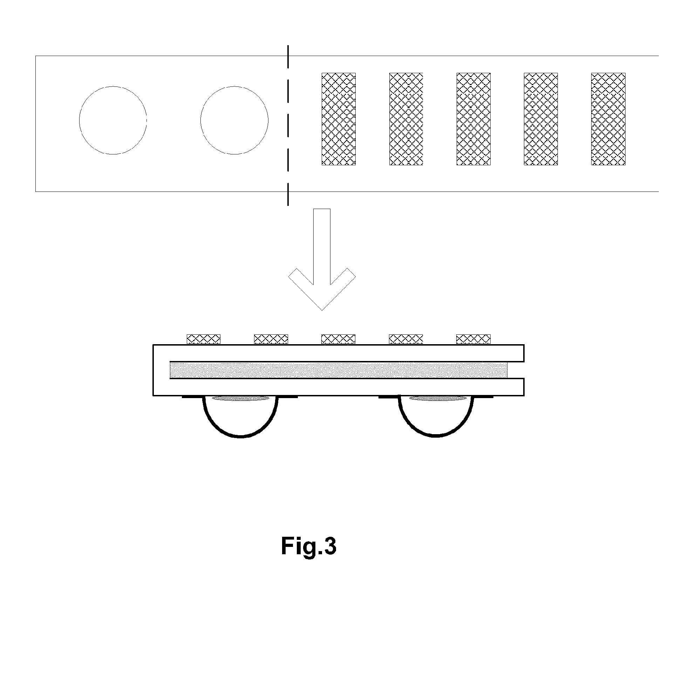

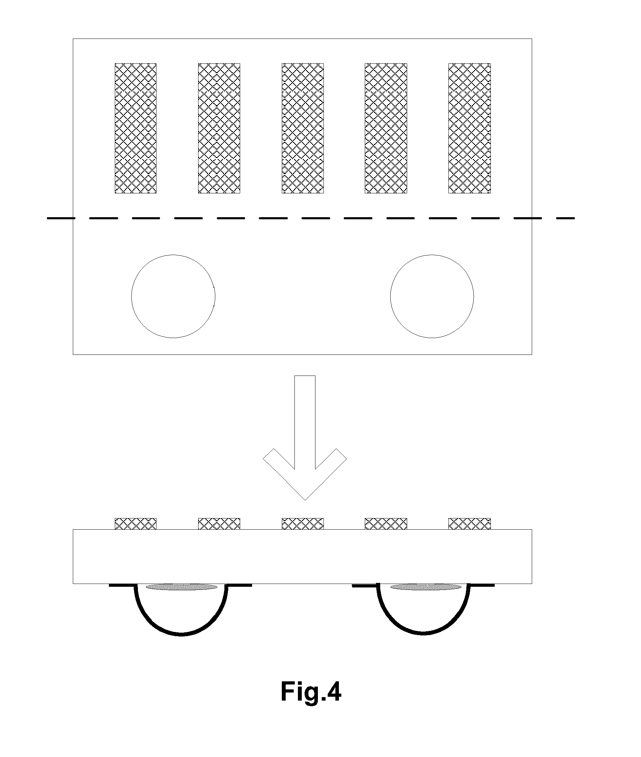

In particular implementation, the touch keys 201 and the mechanical key 203 may be arranged on the same printed circuit board 202, and then printed circuit board 202 may be bent at the middle, so as to form the key device shown in Fig. 2. Figs. 3 and 4 are schematic diagrams showing the formation of a key device of an embodiment of the present invention. As shown in Figs. 3 and 4, the key device may be formed after being bent at the dotted line.

In this way, the touch keys, the printed circuit board and the mechanical key may be arranged within the same key device. A control signal of one path may be generated by contacting the touch keys by a user; and an electrical signal of another path may be generated by the mechanical key by pressing the key body.

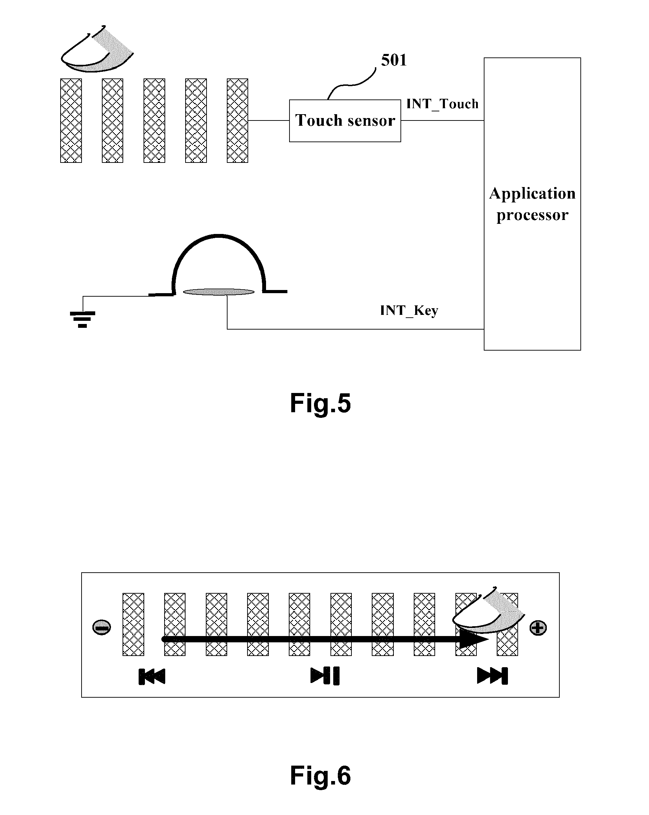

Fig. 5 is a schematic diagram showing generation of signals of two paths of an embodiment of the present invention. As shown in Fig. 5, signals of two paths, INT_Touch and INT_Key, may be generated in a key device, thereby the functions of multiple functional keys may be integrated into a key device, and, thereby, saving space.

In addition, the user may operate by the touch keys, which, in many scenarios (such as Web browsing, Snapshot, and Zoom in/out, etc.), may improve the operability by the user. At the same time, the mechanical key is reserved, which provides better experiences to the user.

In this embodiment, with the capacitive touch sensor, the control signal generated by the printed circuit board may be used to realize a volume function or a camera function.

In an embodiment, the printed circuit board 202 may generate a control signal for focusing or shooting according to the time interval of the change of the capacitance of the capacitive touch sensor.

For example, if the user presses the touch keys 201 (for more than 3 seconds, for example), the capacitance of the capacitive touch sensor 501 will be changed from low to high, and the capacitance is maintained high. At this time, the printed circuit board 202 generates a control signal for focusing.

Or, if the user double clicks the touch keys 201 (touching the touch keys 201 twice, with a time interval of within 0.5 second, for example), the printed circuit board 202 generates a control signal for focusing according to the time interval of the change of the capacitance (for example, the capacitance is changed from low to high and again to low for the first time, and then is changed from low to high and again to low for the second time).

The user may also single click the touch keys 201, and the capacitance of the capacitive touch sensor will be changed from low to high and then from high to low. At this time, the printed circuit board 202 generates a control signal for shooting.

In another embodiment, the touch keys 201 may be multiple, and the printed circuit board 202 may generate a control signal for changing volume according to the change of the capacitance of multiple capacitive touch sensors.

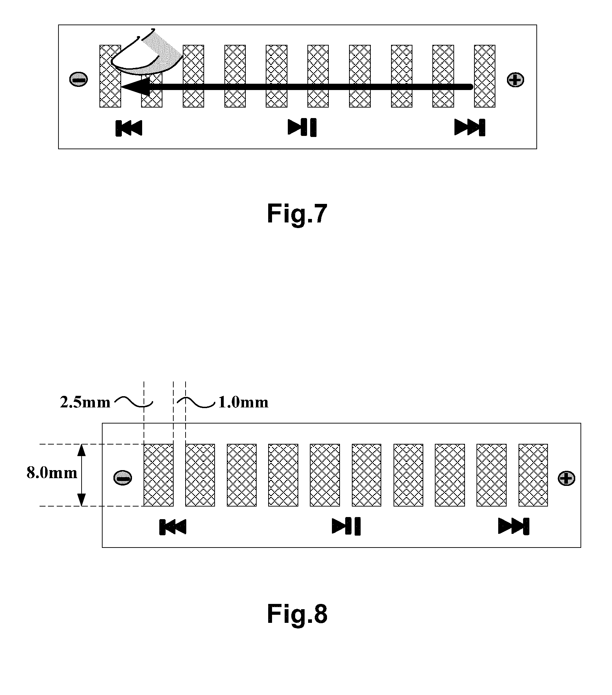

Figs. 6 and 7 show volume control according to the movement of a finger on multiple touch keys. Fig. 6 is a schematic diagram showing volume up of an embodiment of the present invention, and Fig. 7 is a schematic diagram showing volume down of an embodiment of the present invention.

As shown in Fig. 6, a user may move his finger from the left to the right on multiple touch keys 201, thereby contacting multiple touch keys from the left to the right, and the capacitance of multiple capacitive touch sensors connected to the multiple touch keys being changed (for example, the capacitance of the capacitive touch sensor connected to the leftmost touch key being changed from low to high and again to low, and then the capacitance of the capacitive touch sensor connected to an adjacent touch key being changed from low to high and again to low..., until the capacitance of the capacitive touch sensor connected to the rightmost touch key being changed from low to high and again to low), and the printed circuit board 202 may generate a control signal for volume up according to the change of the capacitance.

As shown in Fig. 7, a user may move his finger from the right to the left on multiple touch keys, thereby contacting multiple touch keys 201 from the right to the left, and the capacitance of multiple capacitive touch sensors connected to the multiple touch keys being changed (for example, the capacitance of the capacitive touch sensor connected to the rightmost touch key being changed from low to high and again to low, and then the capacitance of the capacitive touch sensor connected to an adjacent touch key being changed from low to high and again to low..., until the capacitance of the capacitive touch sensor connected to the leftmost touch key being changed from low to high and again to low), and the printed circuit board 202 may generate a control signal for volume down according to the change of the capacitance.

It should be noted that what is described above is just exemplary, and the present invention is not limited thereto. For example, a control signal may be generated after the user double clicks the touch keys. Particular implementation may be determined as actually required.

In this way, a user may not only realize the control of camera by an action of single click or double clicks, but also control the adjustment of the volume by the movement of a finger, realizing the control of volume like playing a piano, and greatly improving the experiences of the user.

Figure 8 is a schematic diagram showing arrangement of touch keys of an embodiment of the present invention. As shown in Fig. 8, multiple touch keys 201 may be arranged linearly. Preferably, the width of each of the touch keys is 2.5 mm, the length is 8.0 mm, and the width between two touch keys is 1.0 mm. With the arrangement above, space may be saved from the viewpoint of implementation, and realization of functions is not affected.

In this embodiment, with the capacitive touch sensor, the control signal generated by the printed circuit board may also be used to realize a navigation function.

In implementation, the touch keys 201 may be multiple, and the multiple touch keys 201 may be arranged circularly. The printed circuit board 202 may generate a control signal for indicating direction according to the change of the capacitance of multiple capacitive touch sensors.

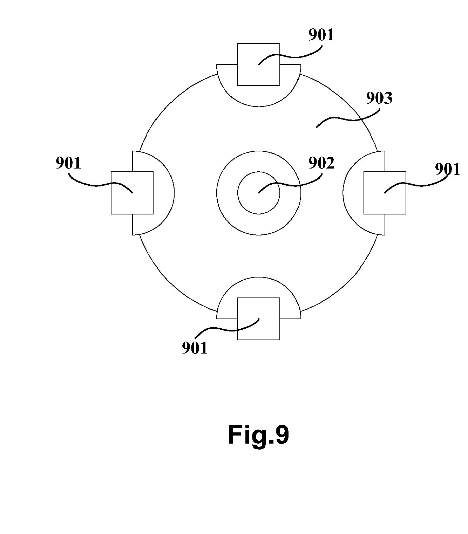

Fig. 9 is a schematic diagram showing realization of a navigation function of an embodiment of the present invention. As shown in Fig. 9, key devices 901 may be arranged at the upper, lower, left and right, and the structure of the key devices 901 may be as shown in Fig. 2. A key device 902 at the center may only be a mechanical key. Thus, the user may perform navigation by only contacting the key devices 901.

Furthermore, capacitive touch keys may be arranged in the whole navigation area. For example, capacitive touch keys are arranged in intermediate area 903 shown in Fig. 9. Thus, the user may realize navigation by moving a finger in the intermediate area 903. In this way, direction may be controlled as using a mouse, greatly improving experiences of the user.

It can be seen from the above embodiment that capacitive touch and mechanical touch may be combined by arranging the touch key, the printed circuit board and the mechanical key in the same key device, which is advantageous to space saving, and is capable of providing better experiences to the user.

The embodiments of the present invention further provide an electronic equipment, including the key device at stated above.

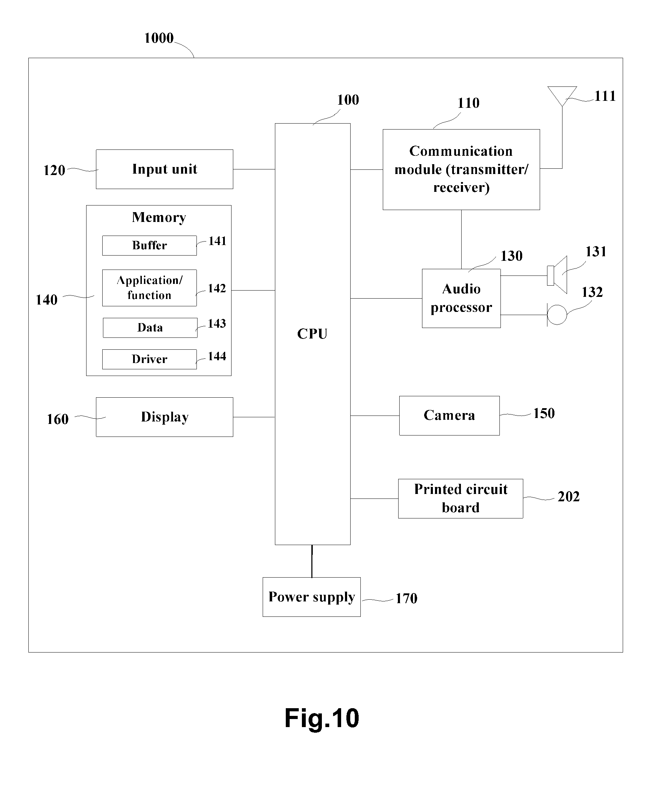

Fig. 10 is a schematic block diagram of the electronic equipment 1000 of the embodiments of the present invention, which includes the above-described printed circuit board 202 which is connected to the above-described capacitive touch sensor and mechanical key 203 (not shown), with the capacitive touch sensor being connected to the above-described touch keys 201 (not shown). Such a figure is exemplary, and other types of structures may be used for supplementing or replacing this structure, so as to realize telecommunications functions or other functions.

As shown in fig. 10, the electronic equipment 1000 may further include a central processing unit 100, a communication module 110, an input unit 120, an audio processing unit 130, a memory 140, a camera 150, a display 160, and a power supply 170.

The central processing unit 100 (sometimes referred to as a controller or control unit, which may include a microprocessor or other processor devices and/or logic devices) receives input and controls every components and operations of the electronic equipment 1000. The input unit 120 provides input to the central processing unit 100. The input unit 120 is, for example, a key or a touch input device. The camera 150 is used to take image data and provide the taken image data to the central processing unit 100, for use in a conventional manner, such as storage, and transmission, etc.

The power supply 170 is used to supply electric power to the electronic equipment 1000. The display 160 is used to display the display objects, such as images, and letters, etc. The display may be, for example, an LCD display, but it is not limited thereto.

The memory 140 is coupled to the central processing unit 100. The memory 140 may be a solid-state memory, such as a read-only memory (ROM), a random access memory (RAM), and a SIM card, etc. It may also be such a memory that stores information when the power is interrupted may be optionally erased and provided with more data. Examples of such a memory are sometimes referred to as an EPROM, etc. The memory 140 may also be certain other types of devices. The memory 140 includes a buffer memory 141 (sometimes referred to as a buffer). The memory 140 may include an application/function storing portion 142 used to store application programs and function programs, or to execute the flow of the operation of the electronic equipment 1000 via the central processing unit 100.

The memory 140 may further include a data storing portion 143 used to store data, such as a contact person, digital data, pictures, voices and/or any other data used by the electronic equipment. A driver storing portion 144 of the memory 140 may include various types of drivers of the electronic equipment for the communication function and/or for executing other functions (such as application of message transmission, and application of directory, etc.) of the electronic equipment.

The communication module 110 is a transmitter/receiver 110 transmitting and receiving signals via an antenna 111. The communication module (transmitter/receiver) 110 is coupled to the central processing unit 100 to provide input signals and receive output signals, this being similar to the case in a conventional mobile phone.

A plurality of communication modules 110 may be provided in the same electronic equipment for various communication technologies, such a cellular network module, a Bluetooth module, and/or wireless local network module, etc. The communication module (transmitter/receiver) 110 is also coupled to a loudspeaker 131 and a microphone 132 via the audio processing unit 130, for providing audio output via the loudspeaker 131 and receiving the audio input from the microphone 132, thereby achieving common telecommunications functions. The audio processing unit 130 may include any appropriate buffers, decoders, and amplifiers, etc. The audio processing unit 130 is further coupled to the central processing unit 100, thereby enabling the recording of voices in this device via the microphone 132 and playing the voices stored in this device via the loudspeaker 131.

The preferred embodiments of the present invention are described above with reference to the drawings. The many features and advantages of the embodiments are apparent from the detailed specification and, thus, it is intended by the appended claims to cover all such features and advantages of the embodiments that fall within the true spirit and scope thereof. Further, since numerous modifications and changes will readily occur to those skilled in the art, it is not desired to limit the inventive embodiments to the exact construction and operation illustrated and described, and accordingly all suitable modifications and equivalents may be resorted to, falling within the scope thereof.

It should be understood that each of the parts of the present invention may be implemented by hardware, software, firmware, or a combination thereof. In the above embodiments, multiple steps or methods may be realized by software or firmware that is stored in the memory and executed by an appropriate instruction executing system. For example, if it is realized by hardware, it may be realized by any one of the following technologies known in the art or a combination thereof as in another embodiment: a discrete logic circuit having a logic gate circuit for realizing logic functions of data signals, application-specific integrated circuit having an appropriate combined logic gate circuit, a programmable gate array (PGA), and a field programmable gate array (FPGA), etc.

The description or blocks in the flowcharts or of any process or method in other manners may be understood as being indicative of including one or more modules, segments or parts for realizing the codes of executable instructions of the steps in specific logic functions or processes, and that the scope of the preferred embodiments of the present invention include other implementations, wherein the functions may be executed in manners different from those shown or discussed, including executing the functions according to the related functions in a substantially simultaneous manner or in a reverse order, which should be understood by those skilled in the art to which the present invention pertains.

The logic and/or steps shown in the flowcharts or described in other manners here may be, for example, understood as a sequencing list of executable instructions for realizing logic functions, which may be implemented in any computer readable medium, for use by an instruction executing system, device or apparatus (such as a system including a computer, a system including a processor, or other systems capable of extracting instructions from an instruction executing system, device or apparatus and executing the instructions), or for use in combination with the instruction executing system, device or apparatus.

The above literal description and drawings show various features of the present invention. It should be understood that those skilled in the art may prepare appropriate computer codes to carry out each of the steps and processes as described above and shown in the drawings. It should be also understood that all the terminals, computers, servers, and networks may be any type, and the computer codes may be prepared according to the disclosure to carry out the present invention by using the apparatus.

Particular embodiments of the present invention have been disclosed herein. Those skilled in the art will readily recognize that the present invention is applicable in other environments. In practice, there exist many embodiments and implementations. The appended claims are by no means intended to limit the scope of the present invention to the above particular embodiments. Furthermore, any reference to "a device to..." is an explanation of device plus function for describing elements and claims, and it is not desired that any element using no reference to "a device to..." is understood as an element of device plus function, even though the wording of "device" is included in that claim.

Although a particular preferred embodiment or embodiments have been shown and the present invention has been described, it is obvious that equivalent modifications and variants are conceivable to those skilled in the art in reading and understanding the description and drawings. Especially for various functions executed by the above elements (portions, assemblies, apparatus, and compositions, etc.), except otherwise specified, it is desirable that the terms (including the reference to "device") describing these elements correspond to any element executing particular functions of these elements (i.e. functional equivalents), even though the element is different from that executing the function of an exemplary embodiment or embodiments illustrated in the present invention with respect to structure. Furthermore, although a particular feature of the present invention is described with respect to only one or more of the illustrated embodiments, such a feature may be combined with one or more other features of other embodiments as desired and in consideration of advantageous aspects of any given or particular application.

## Claims

1. A key device, comprising a key body, wherein the key device further comprises:
one or more touch keys arranged on the key body, the touch keys being contacted such that the capacitance of a capacitive touch sensor is changed;
a printed circuit board, with one side being arranged the touch keys, for inducing the change of the capacitance of the capacitive touch sensor, so as to generate a control signal; and
a mechanical key arranged on the other side of the printed circuit board, when the key body is pressed, the mechanical key being squeezed to generate an electrical signal.

2. The key device according to claim 1, wherein the mechanical key is a dome key.

3. The key device according to either one of claims 1 or 2, wherein the control signal is used to realize a volume function or a camera function.

4. The key device according to any one of claims 1-3, wherein the printed circuit board generates a control signal for focusing or shooting according to the time interval of the change of the capacitance of the capacitive touch sensor.

5. The key device according to any one of claims 1-4, wherein there are multiple touch keys, and the printed circuit board generates a control signal for changing volume according to the change of the capacitance of multiple capacitive touch sensors.

6. The key device according to claim 5, wherein the multiple touch keys are arranged linearly.

7. The key device according to claim 6, wherein the width of each of the touch keys is 2.5 mm, the length is 8.0 mm, and the width between two touch keys is 1.0 mm.

8. The key device according to any one of claims 1-7, wherein the control signal is used to realize a navigation function.

9. The key device according to any one of claims 1-8, wherein there are multiple touch keys, and the printed circuit board generates a control signal for indicating direction according to the change of the capacitance of multiple capacitive touch sensors.

10. The key device according to any one of claims 1-9, wherein the multiple touch keys are arranged circularly.

11. Electronic equipment, comprising the key device as claimed in any one of claims 1-10.
